(19) Europäisches Patentamt
European Patent Office
Office européen des brevets

(11) **EP 2 786 418 B1**

(12) **EUROPÄISCHE PATENTSCHRIFT**

(45) Veröffentlichungstag und Bekanntmachung des Hinweises auf die Patenterteilung:
**04.04.2018 Patentblatt 2018/14**

(51) Int Cl.:
*H01L 29/861* (2006.01)   *H01L 29/872* (2006.01)

(21) Anmeldenummer: **12794663.0**

(22) Anmeldetag: **12.11.2012**

(86) Internationale Anmeldenummer:
**PCT/EP2012/072378**

(87) Internationale Veröffentlichungsnummer:
**WO 2013/079304 (06.06.2013 Gazette 2013/23)**

(54) **HOCHSPANNUNGS-TRENCH-JUNCTION-BARRIER-SCHOTTKYDIODE**

HIGH-VOLTAGE TRENCH JUNCTION BARRIER SCHOTTKY DIODE

DIODE SCHOTTKY À BARRIÈRE, À JONCTION, À TRANCHÉES, À HAUTE TENSION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **01.12.2011 DE 102011087591**

(43) Veröffentlichungstag der Anmeldung:
**08.10.2014 Patentblatt 2014/41**

(73) Patentinhaber: **Robert Bosch GmbH**
**70442 Stuttgart (DE)**

(72) Erfinder:
• **QU, Ning**
**72770 Reutlingen (DE)**

• **GOERLACH, Alfred**
**72127 Kusterdingen (DE)**

(56) Entgegenhaltungen:
**EP-A1- 1 139 433   WO-A1-2006/048387**
**JP-A- 2000 252 478**

• **BALIGA ET AL: "Analysis of junction-barrier-controlled Schottky (JBS) rectifier characteristics", SOLID STATE ELECTRONICS, ELSEVIER SCIENCE PUBLISHERS, BARKING, GB, Bd. 28, Nr. 11, 1. November 1985 (1985-11-01), Seiten 1089-1093, XP025754841, ISSN: 0038-1101, DOI: 10.1016/0038-1101(85)90188-1 [gefunden am 1985-11-01]**

EP 2 786 418 B1

**Beschreibung**

Die Erfindung betrifft eine Schottkydiode, die sich für Hochspannungsanwendungen eignet und des Weiteren eine niedrige Flussspannung, einen niedrigen Leckstrom, kleine Schaltverluste und eine hohe Robustheit aufweist.

Stand der Technik

Für Hochspannungsanwendungen werden in der Regel Hochspannungs-PN-Dioden eingesetzt. Derartige Hochspannungs-PN-Dioden weisen in vorteilhafter Weise einen niedrigen Leckstrom sowie eine hohe Robustheit auf. Nachteile von derartigen Hochspannungs-PN-Dioden bestehen darin, dass sie eine hohe Flussspannung und eine hohe Schaltverlustleistung haben.

In einer derartigen Hochspannungs-PN-Diode wird die Spannung hauptsächlich von dem bei derartigen Dioden vorgesehenen schwach dotierten Gebiet übernommen. Im Falle eines Betriebes in Flussrichtung werden Elektronen und Löcher in das schwach dotierte Gebiet injiziert. Bei hoher Stromdichte herrscht Hochinjektion im schwach dotierten Gebiet und die Elektronen- und Löcherdichte ist höher als die Dotierkonzentration des schwach dotierten Gebietes. Dadurch wird die Leitfähigkeit des schwach dotierten Gebietes erhöht. Dies führt in vorteilhafter Weise zu einer Reduzierung der Flussspannung. Allerdings beginnt der Strom einer Hochspannungs-PN-Diode bei Raumtemperatur erst ab etwa einer Flussspannung UF = 0,7 V zu fließen. Unter normalen Betriebsbedingungen, beispielsweise bei einer Stromdichte, die größer als 100 A/cm$^2$ ist, steigt die Flussspannung UF auf Werte an, die größer als 1 V sind. Damit ist eine entsprechend hohe, unerwünschte Verlustleistung verbunden. Da eine Hochspannungs-PN-Diode ein dickes schwach dotiertes Gebiet benötigt, ist der Spannungsabfall in Flussrichtung über dem schwach dotierten Gebiet trotz der Leitfähigkeitsmodulation relativ groß.

Die Ladungsträger (Elektronen und Löcher), die während des Betriebs in Flussrichtung in das schwach dotierte Gebiet injiziert und dort gespeichert werden, müssen beim Abschalten, beispielsweise bei einer abrupten Stromkommutierung, erst abgebaut werden, bevor die Hochspannungs-PN-Diode überhaupt in der Lage ist, wieder Sperrspannung zu übernehmen. Daher fließt der Strom bei einer abrupten Stromkommutierung zuerst in Sperrrichtung weiter, bis die gespeicherten Ladungsträger abgebaut bzw. ausgeräumt sind. Dieser Vorgang, also die Höhe und die Dauer des Ausräumstroms zum Abbau der gespeicherten Ladungsträger, ist in erster Linie von der Menge der im schwach dotierten Gebiet gespeicherten Ladungsträger bestimmt. Ein höherer und länger dauernder Ausräumstrom bedeutet eine höhere Abschaltverlustleistung.

Eine Verbesserung des Schaltverhaltens bieten Schottkydioden (Metall-Halbleiterkontakte bzw. Silizid-Halbleiterkontakte). Bei Schottkydioden findet keine Hochinjektion im Flussbetrieb statt und daher entfällt das Ausräumen der Minoritätsladungsträger beim Abschalten. Sie schalten schnell und nahezu verlustlos. Allerdings sind damit hohe Leckströme verbunden, insbesondere bei Hochtemperatur, mit starker Spannungsabhängigkeit wegen des Barrier-Lowering-Effekts. Außerdem sind für hohe Sperrspannungen wieder dicke und niedrig dotierte Halbleiterschichten notwendig, was bei hohen Strömen zu nicht akzeptablen, hohen Flussspannungen führt. Deswegen sind Leistungs-Schottkydioden in Silizium-Technik - trotz guten Schaltverhaltens - für Sperrspannungen über etwa 100 V nicht geeignet.

Aus der DE 197 40 195 C2 ist eine Schottkydiode, nachfolgend auch als Cool-SBD bezeichnet, bekannt. Bei dieser Cool-SBD wird durch das Einbringen von dotierten, alternierend angeordneten p- und n-leitenden Säulen unter einem Schottky-Kontakt eine signifikante Absenkung des Widerstandes möglich. Wenn die Säulenbreite reduziert wird, können die Säulendotierungen erhöht werden. Dabei ist die Dotierung der p- und n-Säulen so gewählt, dass bei Anliegen von Sperrspannung alle Dotieratome ionisiert sind. Dieses Prinzip wird auch als Superjunction-Prinzip (SJ) bezeichnet. Da in einer Cool-SBD im Flussbetrieb hoher Stromdichte Hochinjektion stattfindet, wird das ideale Schaltverhalten einer reinen Schottkydiode nicht erreicht, gegenüber einer PN-Diode aber deutlich verbessert. Die geringe Flussspannung der PN-Diode wird aber allerdings bei hohen Strömen nicht erreicht.

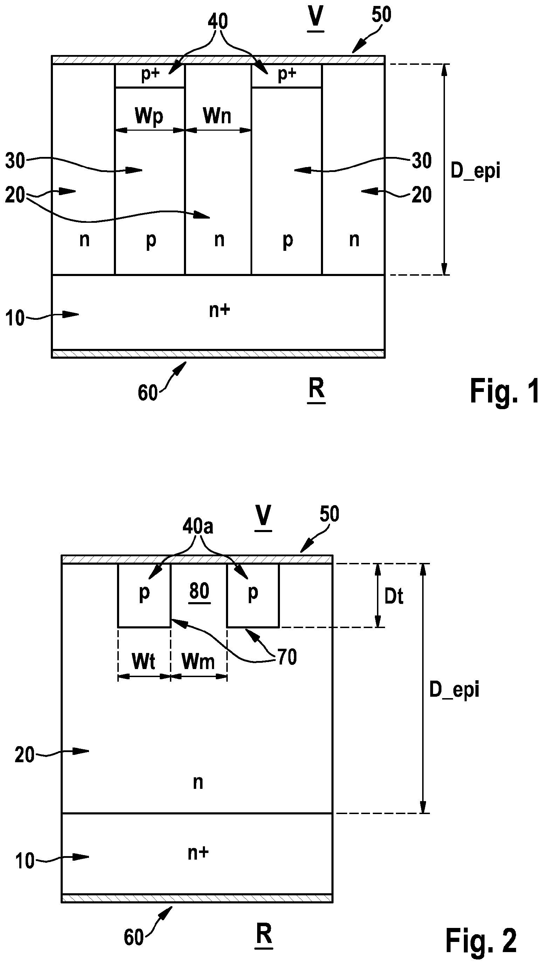

Ein Beispiel für eine derartige bekannte Cool-SBD ist in der Figur 1 gezeigt. Diese Cool-SBD weist ein n$^+$-Substrat 10 auf, auf welchem eine n-Epischicht 20 der Dicke D_epi und der Dotierungskonzentration ND angeordnet ist. Die n-Epischicht 20 enthält eingeätzte Gräben 30 (Trenches), die mit p-dotiertem Silizium der Dotierungskonzentration NA bzw. in den oberen Bereichen 40 mit p$^+$-dotiertem Silizium gefüllt sind. Die Weite der n-Epischicht zwischen benachbarten Gräben 30 ist Wn, die der Gräben 30 ist Wp. Dotierungen und Weiten sind so gewählt, dass diese Bereiche bei Anliegen der vollen Sperrspannung verarmt sind (Superjunction Prinzip). Dies ist etwa bei NA·Wp = ND·Wn = 10$^{12}$ cm$^{-2}$ der Fall. Auf der Vorderseite V der vorzugsweise als Chip realisierten Cool-SBD sind die n-dotierten Bereiche 20 und die p$^+$-dotierten Bereiche 40 mit einer durchgehenden Metallschicht 50 bedeckt, die mit den n-dotierten Bereichen 20 einen Schottky-Kontakt und mit den p$^+$-dotierten Bereichen 40 einen ohmschen Kontakt bildet. Die Metallschicht 50 stellt die Anodenelektrode der Cool-SBD dar. Durch die Wahl eines entsprechenden Metalls 50 kann die Barrierenhöhe der Schottkydiode 50-20 eingestellt werden. Beispielsweise kann als Metallschicht 50 Nickel oder NiSi verwendet werden. Über der funktionalen Schicht 50 können sich ggf. noch weitere - nicht eingezeichnete Metallschichten - befinden, um die Oberfläche beispielsweise lötfähig oder bondbar zu machen. Auf der Chiprückseite R befindet sich ebenfalls eine Metallschicht oder ein Metallsystem 60, die bzw. das den ohmschen Kontakt zum hoch n⁺-dotierten Substrat 10 bildet. Üblicherweise ist diese Schicht bzw. Schichtenfolge zur Löt- oder einer sonstigen Montage geeignet. Sie kann beispielsweise aus einer Abfolge von Cr / NiV und Ag bestehen. Das Metallsystem 60 bildet den Kathodenanschluss der Cool-SBD.

Man kann die vorstehend beschriebene Anordnung als eine Parallelschaltung von Schottky- und PN-Dioden ansehen. Dabei bildet der Metallkontakt 50 mit den n-dotierten Säulen 20 Schottkydioden. Die PN-Struktur wird durch die Schichtenfolge bestehend aus p⁺-Gebiet 40, p-Gebiet 30 und Substrat 10 als p⁺/p/n⁺-Struktur gebildet.

Beim Anliegen einer Sperrspannung verarmen die p- und n-dotierten Säulen. Mit abnehmender Breite Wp und Wn kann die Dotierung - zumindest bis zu einer gewissen Grenze, die daraus resultiert, dass die Raumladungszonen schon bei kleiner Spannung zusammenstoßen - erhöht werden. Dies reduziert in Flussrichtung den Bahnwiderstand der Schottkydioden 50-20-10. Die Flussspannungen sind deshalb niedriger als bei einer einfachen Schottkydiode, die bei gleicher Sperrspannung mit einer niedrigeren Dotierung ausgelegt werden muss. Zusätzlich fließt in Flussrichtung noch etwas Strom durch die PN-Dioden. Dadurch wird die Flussspannung, insbesondere bei hoher Stromdichte, weiter reduziert. Allerdings müssen die Minoritätsladungsträger beim Abschalten mit nachteiligen Effekten für die Schaltzeit auch wieder ausgeräumt werden.

Ein Bauteil ähnlicher Geometrie wie das Bauteil der vorliegenden Offenbarung ist beschrieben in BALIGA ET AL: "Analysis of junction-barrier-controlled Schottky (JBS) rectifier characteristics", SOLID STATE ELEC-TRONICS, ELSEVIER SCIENCE PUBLISHERS, BARK-ING, GB, Bd. 28, Nr. 11, 1. November 1985 (1985-11-01), Seiten 1089-1093.

Offenbarung der Erfindung

Eine Schottkydiode mit den im Anspruch 1 angegebenen Merkmalen eignet sich für Hochspannungsanwendungen und weist in vorteilhafter Weise eine niedrige Flussspannung, einen niedrigen Leckstrom, kleine Schaltverluste und eine hohe Robustheit auf. Diese Vorteile werden dadurch erzielt, dass die Schottkydiode gemäß der Erfindung ein n⁺-Substrat, eine n-Epischicht, die eine Dicke aufweist, mindestens zwei in die n-Epischicht eingebrachte Gräben, die jeweils eine Breite und eine Tiefe aufweisen, Mesabereiche zwischen benachbarten Gräben, wobei die Mesabereiche jeweils eine Breite aufweisen, eine als Kathodenelektrode dienende Metallschicht an der Rückseite der Schottkydiode und ein als Anodenelektrode dienende Metallschicht an der Vorderseite der Schottkydiode aufweist, wobei für die Tiefe der Gräben und die Dicke der n-Epischicht die fol-gende Beziehung gilt:

$$K \cdot Dt < D\_epi,$$

wobei Dt die Tiefe der Gräben, D_epi die Dicke der n-Epischicht und K ein Faktor ist, für den gilt:

$$K > 4.$$

Weitere vorteilhafte Eigenschaften der Erfindung ergeben sich aus deren nachfolgender beispielhafter Erläuterung anhand der Zeichnung. Es zeigt

Figur 2  eine Skizze zur Veranschaulichung einer Schottkydiode gemäß der Erfindung,

Figur 3  eine Skizze zur Veranschaulichung einer al-ternativen Ausführungsform für eine Schott-kydiode gemäß der Erfindung,

Figur 4  ein Diagramm, in welchem Flusskennlinien veranschaulicht sind,

Figur 5  ein Diagramm, in welchem Elektronenverteilungen veranschaulicht sind,

Figur 6  ein Diagramm, in welchem Löcherverteilungen veranschaulicht sind,

Figur 7  ein Diagramm, in welchem Speicherladungsverläufe veranschaulicht sind, und

Figur 8  eine Skizze zur Veranschaulichung einer weiteren alternativen Ausführungsform für eine Schottkydiode gemäß der Erfindung.

Die Figur 2 zeigt eine Skizze zur Veranschaulichung einer Schottkydiode gemäß der Erfindung. Diese Schottkydiode, die vorzugsweise in Form eines Chips realisiert wird, wird nachfolgend auch als Hochspannungs-Trench-Junction-Barrier-Schottkydiode bzw. HV-TJBS bezeichnet.

Die in der Figur 2 gezeigte HV-TJBS weist ein n⁺-Substrat 10, eine n-Epischicht 20, in die n-Epischicht 20 eingeätzte Gräben (Trenches) 70, eine Metallschicht 50 an der Chipvorderseite V als Anodenelektrode und an der Chiprückseite R eine Metallschicht 60 als Kathodenelektrode auf. Die Gräben 70 werden mit hoch p-dotiertem Silizium oder Polysilizium 40a gefüllt. Die Metallschichten 50 und 60 können auch aus zwei oder mehr unterschiedlichen, übereinander liegenden Metallschichten bestehen. Der Übersichtlichkeit wegen ist dies in der Figur 2 nicht eingezeichnet. Elektrisch gesehen ist die HV-TJBS eine Kombination einer Trench-PN-Diode (PN-Übergang zwischen den p-dotierten Gräben 70 als Anode und der n-Epischicht 20 als Kathode) und einer Schottkydiode (Schottky-Barriere zwischen der Metallschicht 50 als Anode und der schwach dotierten n-Epischicht 20 als Kathode). Insbesonders ist die Dotierung der n-Epischicht so gewählt, dass bei Betrieb mit hohen Strömen in Flussrichtung in ihr Hochinjektion vorliegt.

In Flussrichtung fließen Ströme zuerst nur durch die Schottkydiode. Wegen fehlender lateraler p-Diffusion ist die effektive Fläche für den Stromfluss in Flussrichtung bei der HV-TJBS deutlich größer als in einer konventionellen Junction-Barrier-Schottkydiode ohne Trench-Struktur. Mit steigenden Strömen fließen Flussströme zunehmend auch durch den PN-Übergang.

In Sperrrichtung dehnen sich die Raumladungszonen mit steigender Spannung aus und stoßen bei einer Spannung, die kleiner als die Durchbruchspannung der HV-TJBS ist, in der Mitte des Bereichs zwischen den benachbarten p-Gräben 70 zusammen. Dadurch wird der für hohe Sperrströme verantwortliche Schottky-Effekt abgeschirmt und somit die Sperrströme reduziert. Dieser Abschirmeffekt ist stark von den Strukturparametern Dt (Tiefe des Grabens) und Wm (Abstand zwischen den Gräben) abhängig. Die Abschirmwirkung der HV-TJBS dieser Erfindung ist viel effektiver als bei konventionellen JBS ohne Trench-Struktur. Auch im Vergleich zu einer Cool-SBD ist die Abschirmwirkung einer HV-TJBS deutlich stärker, da eine HV-TJBS über einen abrupten PN-Übergang statt einer Ladungskompensation der p und n-Gebiete verfügt. Die p-Gebiete 40a sind wesentlich höher dotiert als das n-Gebiet 20. Es herrscht keine SJ-Bedingung, sondern es gilt NA·Wt >> ND·Wm, wobei NA die Dotierungskonzentration in den Gräben 70, Wt die Breite der Gräben 70, ND die Dotierungskonzentration in der n-Epischicht 20 und Wm die Breite der n-Epischicht zwischen zwei Gräben 70 ist.

Die Tiefe Dt der Gräben ist wesentlich kleiner als die Dicke D_epi der n-Epischicht 20 gewählt. Vorzugsweise gilt:

$$K \cdot Dt < D\_epi,$$

wobei K > 4.

Durch diese Dimensionierung wird erreicht, dass ein möglichst großer Bereich der n-Epischicht 20 mit Ladungsträgern überflutet wird bzw. dass in einem möglichst großen Bereich eine Ladungsträgermodulation (Hochinjektion) vorliegt.

Eine HV-TJBS dieser Erfindung bietet durch ihre Klammerfunktion eine hohe Robustheit. Die Durchbruchspannung BV_pn der PN-Diode wird so ausgelegt, dass BV_pn niedriger als die Durchbruchspannung BV_schottky der Schottkydiode ist und zudem der Durchbruch am Boden der Gräben 70 stattfindet. Im Durchbruchsbetrieb fließt der Strom dann nur durch den PN-Übergang. Flussbetrieb und Durchbruchsbetrieb finden an unterschiedlichen Orten statt und sind damit geometrisch getrennt. Die HV-TJBS dieser Erfindung verfügt deshalb über eine ähnliche Robustheit wie eine Hochspannungs-PN-Diode.

Bei vergleichbaren Durchbruchsspannungen, z. B. 650 V, sind die Sperrströme bei Raumtemperatur der HV-TJBS dieser Erfindung und einer PN-Diode vergleichbar und mehr als eine Größenordnung kleiner als bei einer Cool-SBD. Bei Hochtemperatur sind die Leckströme einer HV-TJBS deutlich erhöht wegen der Temperaturabhängigkeit des Leckstroms eines Schottky-Kontakts, bleiben jedoch nach wie vor deutlich niedriger als bei einer Cool-SBD.

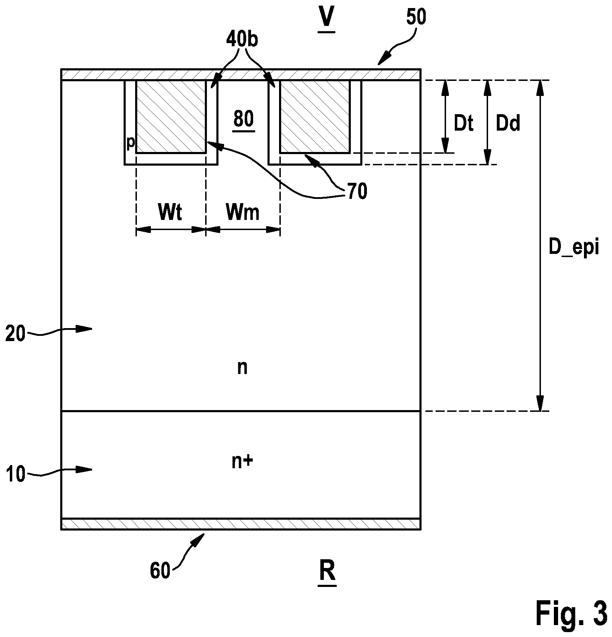

Die Figur 3 zeigt eine Skizze zur Veranschaulichung einer alternativen Ausführungsform für eine Schottkydiode gemäß der Erfindung. Bei dieser alternativen Ausführungsform weist die Schottkydiode ebenfalls ein n⁺-Substrat 10, eine n-Epischicht 20, in die n-Epischicht 20 eingeätzte Gräben 70 (Trenches), eine als Anodenelektrode dienende Metallschicht 50 an der Vorderseite V der in Form eines Chips realisierten Schottkydiode und eine als Kathodenelektrode dienende Metallschicht 60 an der Rückseite R der in Form eines Chips realisierten Schottkydiode auf. Die Metallschicht 50 erstreckt sich bei dieser Ausführungsform bis in die Oberfläche der Gräben 70 hinein und kann auch die Gräben 70 vollständig füllen.

Bei dieser Ausführungsform werden die PN-Übergänge der Schottkydiode durch eine flache Diffusion realisiert. Zu diesem Zweck erfolgt eine Belegung der Gräben 70 mit Bor als Dotiermaterial und eine anschließende flache p-Diffusion, die in der Figur 3 mit der Bezugszahl 40b angedeutet ist. Durch eine fette und flache Diffusion mit einer Eindringtiefe, die bei einer Grabentiefe von beispielsweise 2 μm beispielsweise 0,2 μm beträgt, sind bei dieser Ausführungsform die Abschirmwirkung von Schottky-Effekten und die Sperrfähigkeit ähnlich wie bei der anhand der Figur 2 beschriebenen Schottkydiode, bei welcher die Gräben mit p-dotiertem Silizium oder p-dotiertem Polysilizium gefüllt sind. Auch eine hohe Stromtragfähigkeit in Flussrichtung und eine hohe Robustheit sind bei dieser alternativen Ausführungsform gegeben.

Ein Vorteil dieser Ausführungsform im Vergleich zu der in der Figur 2 gezeigten Ausführungsform besteht in einer Prozessvereinfachung, die im Falle einer Belegung der Gräben und anschließender Diffusion im Vergleich zu einem Ausfüllen von Gräben gegeben ist.

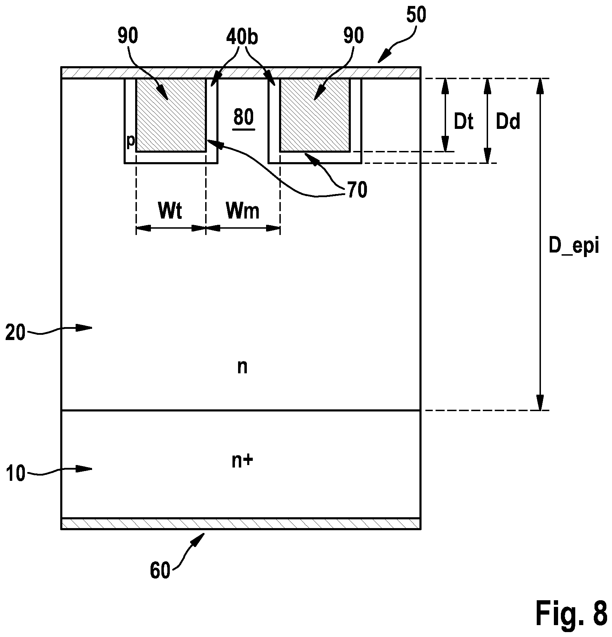

Die Figur 8 zeigt eine alternative Ausführungsform, die auf dem Ausführungsbeispiel gemäß der Figur 3 basiert. Der Unterschied besteht darin, dass sich die Metallschicht 50 nicht bis in die Gräben hinein erstreckt, sondern dass sich in den Gräben 70 eine hoch p-dotierte Schicht 90 aus Polysilizium befindet.

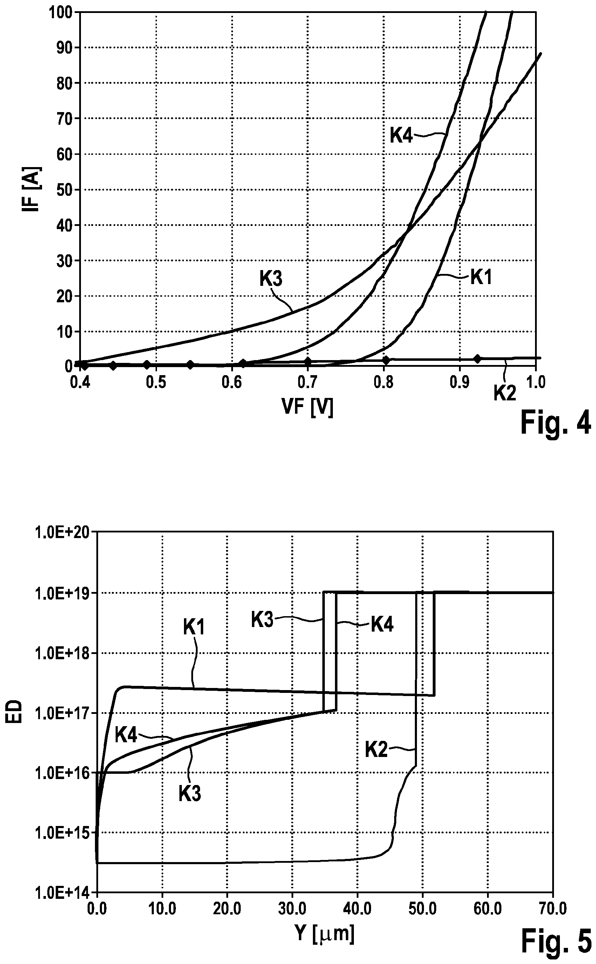

Die Figur 4 zeigt ein Diagramm, in welchem Flusskennlinien veranschaulicht sind, wobei längs der Abszisse die Fluss- bzw. Durchlassspannung VF in Volt und längs der Ordinate der Fluss- bzw. Durchlassstrom IF in Ampere aufgetragen sind. Diese Flusskennlinien wurden unter Verwendung von 600 V-Bauelementen mit einer Chipfläche von 26 mm² bei einer Temperatur von 25°C ermittelt. Die Kennlinie K1 ist die Flusskennlinie einer herkömmlichen Hochspannungs-PN-Diode aus Silizium. Die Kennlinie K2 ist die Flusskennlinie einer Silizium- Schottkydiode (Si-SBD). Die Kennlinie K3 ist die Flusskennlinie einer Cool-SBD. Die Kennlinie K4 ist die Flusskennlinie einer HV-TJBS gemäß der vorliegenden Erfindung.

Die Barrierehöhe der Schottkydiode, der Cool-SBD und der erfindungsgemäßen HV-TJBS beträgt dabei jeweils 0,72 eV.

Wie aus diesen Kennlinien ersichtlich ist, ist die Flussspannung einer HV-TJBS bis zu einer Stromdichte von ca. 400 A/cm$^2$ (entspricht für eine Chipfläche von 26mm$^2$ etwa 100 A) kleiner als bei einer PN-Diode. Dies ist darauf zurückzuführen, dass ein großer Anteil der Ströme durch den Schottky-Kontakt fließt. Im Vergleich zu einer Cool-SBD mit gleicher Barrierehöhe weist eine HV-TJBS Vorteile bei Stromdichten auf, die größer sind als etwa 150 A/cm$^2$. Dies ist darauf zurückzuführen, dass bei einer hohen Stromdichte die Hochinjektion in einer Cool-SBD nicht so stark wie in einer HV-TJBS ist.

Die Figur 5 zeigt ein Diagramm, in welchem Elektronenverteilungen in der Mitte des Mesabereiches 80 veranschaulicht sind, wobei längs der Abszisse der Abstand Y zur Chipvorderseite in μm und längs der Ordinate die Elektronendichte ED pro cm$^3$ aufgetragen sind. Auch diese Kennlinien wurden unter Verwendung von 600 V-Bauelementen mit einer Chipfläche von 26 mm$^2$ bei einer Temperatur von 25° C ermittelt. Die Kennlinie K1 zeigt die Elektronenverteilung einer herkömmlichen Hochspannungs-PN-Diode aus Silizium. Die Kennlinie K2 zeigt die Elektronenverteilung einer Silizium-Schottkydiode (Si-SBD). Die Kennlinie K3 zeigt die Elektronenverteilung bei einer Cool-SBD. Die Kennlinie K4 zeigt die Elektronenverteilung bei einer HV-TJBS gemäß der Erfindung. Die Barrierehöhe der Schottkydiode, der Cool-SBD und der erfindungsgemäßen HV-TJBS beträgt auch hier jeweils 0,72 eV. Bei der HV-TJBS wurde die dargestellte Elektronendichte in der Mitte des Mesabereiches ermittelt. Bei der Cool-SBD wurde die dargestellte Elektronendichte in der Mitte des n-dotierten Bereiches ermittelt.

Aus den in der Figur 5 gezeigten Verläufen der Elektronenverteilung ist ersichtlich, dass bei der erfindungsgemäßen Anordnung die Überflutung des n-dotierten Gebiets mit Elektronen vergleichbar einer Cool_SBD ist und wesentlich geringer ist als bei einer Hochspannungs-PN-Diode aus Silizium.

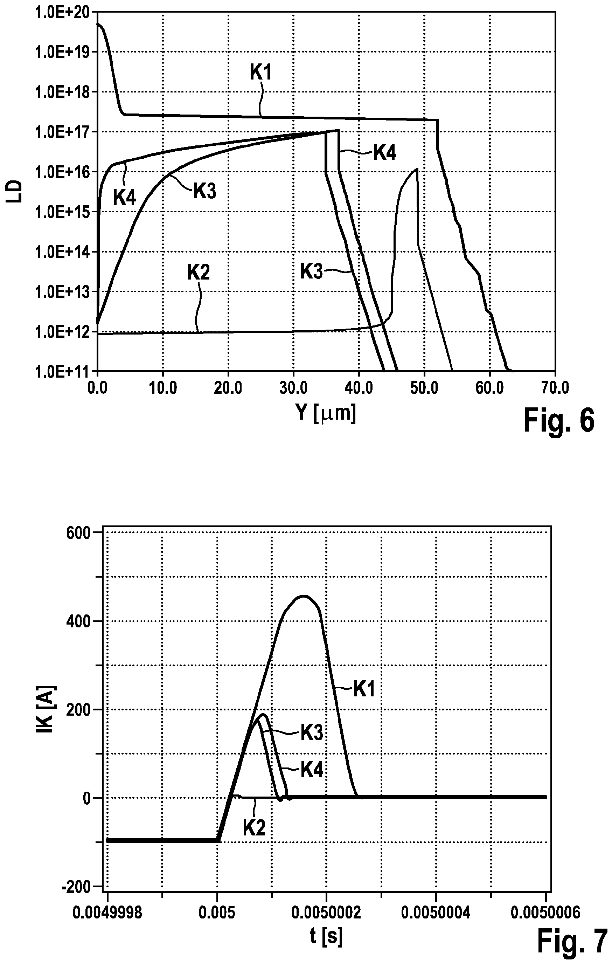

Die Figur 6 zeigt ein Diagramm, in welchem Löcherverteilungen veranschaulicht sind, wobei längs der Abszisse der Abstand Y zur Chipvorderseite in μm und längs der Ordinate die Löcherdichte LD pro cm$^3$ aufgetragen sind. Auch diese Kennlinien wurden unter Verwendung von 600 V-Bauelementen mit einer Chipfläche von 26mm$^2$ bei einer Temperatur von 25°C ermittelt. Die Kennlinie K1 zeigt die Löcherdichte einer herkömmlichen Hochspannungs-PN-Diode aus Silizium. Die Kennlinie K2 zeigt die Löcherdichte einer Silizium-Schottkydiode (SI-SBD). Die Kennlinie K3 zeigt die Löcherdichte einer Cool-SBD. Die Kennlinie K4 zeigt die Löcherdichte einer HV-TJBS gemäß der Erfindung. Die Barrierehöhe der Schottkydiode, der Cool-SBD und der erfindungsgemäßen HV-TJBS beträgt auch hier jeweils 0,72 eV. Bei der HV-TJBS wurde die dargestellte Elektronendichte in der Mitte der Mesabereiche ermittelt. Bei der Cool-SBD wurde die dargestellte Elektronendichte in der Mitte des n-dotierten Bereiches ermittelt.

Aus den in der Figur 6 gezeigten Verläufen der Löcherverteilungen ist ersichtlich, dass bei der erfindungsgemäßen Anordnung die Überflutung des n-dotierten Gebiets mit Löchern vergleichbar einer Cool_SBD ist und wesentlich geringer als bei einer Hochspannungs-PN-Diode aus Silizium. Die gespeicherte Ladung, die beim Abschalten ausgeräumt werden muss, ist bei der erfindungsgemäßen Anordnung geringer als bei der Hochspannungs-PN-Diode.

Die Figur 7 zeigt ein Diagramm, in welchem Speicherladungsverläufe veranschaulicht sind, wobei längs der Abszisse die Zeit t in Sekunden und längs der Ordinate der Kathodenstrom IK in Ampere aufgetragen sind. Diese Speicherladungsverläufe werden unter Verwendung von 600 V-Bauelementen mit einer Chipfläche von 26 mm$^2$ bei einer Temperatur von 25°C ermittelt, wobei des Weiteren das Abschalten eines Flussstromes IF von 100 A gegen eine Sperrspannung VR von 300 V mit einer Stromänderung dl/dt von 4,4 kA/μs als Parameter verwendet wurden. Die Kennlinie K1 zeigt den Speicherladungsverlauf bei einer herkömmlichen Hochspannungs-PN-Diode aus Silizium. Die Kennlinie K2 zeigt den Speicherladungsverlauf bei einer Silizium-Schottkydiode (Si-SBD). Die Kennlinie K3 zeigt den Speicherladungsverlauf bei einer Cool-SBD. Die Kennlinie K4 zeigt den Speicherladungsverlauf bei einer HV-TJBS gemäß der Erfindung. Die Barrierehöhe der Schottkydiode, der Cool-SBD und der erfindungsgemäßen HV-TJBS beträgt jeweils 0,72 eV.

Aus den in der Figur 7 gezeigten Speicherladungsverläufen ist unter anderem ersichtlich, dass das Schaltverhalten einer erfindungsgemäßen HV-TJBS zwar geringfügig ungünstiger ist als das Schaltverhalten einer Cool-SBD, aber wesentlich besser ist als das Schaltverhalten einer herkömmlichen Hochspannungs-PN-Diode aus Silizium.

Die Erfindung stellt nach alledem eine Hochspannngs-Trench-Junction-Barrier-Schottkydiode bereit, bei welcher es sich um eine spezielle Kombination einer Trench-PN-Diode mit einer herkömmlichen Schottkydiode handelt. Die Durchbruchspannung der PN-Diode wird derart ausgelegt, dass sie niedriger ist als die Durchbruchspannung der Schottkydiode. Die HV-TJBS gemäß der vorliegenden Erfindung verfügt über eine hohe Stromtragfähigkeit in Flussrichtung, hat eine effektive Abschirmwirkung von Schottky-Effekten in Sperrrichtung und daher einen niedrigen Leckstrom und eine hohe Robustheit aufgrund der Klammerfunktion der Trench-PN-Diode.

Die Vorteile einer HV-TJBS gemäß der Erfindung im Vergleich zu einer Hochspannungs-PN-Diode bestehen in einer niedrigeren Flussspannung bis zu einer hohen Stromdichte aufgrund einer Verwendung einer geeigneten Barrierehöhe des Schottky-Kontakts in Kombination mit einer Hochinjektion bei hoher Stromdichte und einer wesentlich kleineren Abschaltverlustleistung, da im Flussbetrieb durch den Schottky-Kontakt weniger Ladungsträger in das schwach dotierte Gebiet injiziert und dort gespeichert werden.

Die Vorteile einer HV-TJBS gemäß der Erfindung im Vergleich zu einer Hochspannungs-Schottkydiode bestehen in einer wesentlich niedrigeren Flussspannung bei hoher Stromdichte, da die Leitfähigkeit des schwach dotierten Gebiets durch Hochinjektion stark erhöht ist, einem wesentlich niedrigeren Leckstrom aufgrund der Abschirmung des Schottky-Effekts mit Hilfe der Trench-PN-Struktur und einer deutlich höheren Robustheit aufgrund der Klammerfunktion der Trench-PN-Diode.

Die Vorteile einer HV-TJBS gemäß der Erfindung im Vergleich zu einer Cool-SBD bestehen in einer niedrigeren Flussspannung bei hoher Stromdichte durch eine stärkere Hochinjektion und einem niedrigeren Leckstrom aufgrund einer wesentlich effektiveren Abschirmung des Schottky-Effektes.

Eine Schottkydiode gemäß der Erfindung kann alternativ zu den oben anhand der Figuren 2 und 3 beschriebenen Ausführungsformen auch dadurch realisiert werden, dass alle ihre oben beschriebenen Halbleiterschichten den jeweils entgegengesetzten Leitfähigkeitstyp aufweisen und die Bezeichnungen des Anoden- und Kathodenanschlusses vertauscht sind.

Bei der oben anhand der Figur 3 bzw. Figur 8 beschriebenen Ausführungsform kann auch ein anderer p-Dotierstoff Verwendung finden.

Die oben anhand der Figur 3 bzw. Figur 8 beschriebene Belegung erfolgt vorzugsweise durch eine Gasphasenbelegung oder eine Implantation.

Bei allen vorstehend angegebenen Ausführungsformen ist eine Tiefe der Gräben von ca. 2 $\mu$m für eine 600 V-HV-TJBS ausreichend.

Bei der oben anhand der Figur 2 beschriebenen Ausführungsform können die Gräben vollständig oder nur zum Teil mit p-dotiertem Silizium oder p-dotiertem Polysilizium gefüllt sein.

Die oben beschriebenen Metallschichten 50 und 60 können jeweils aus einer, zwei oder mehr übereinander liegenden Metalllagen bestehen. Die oben beschriebenen Gräben können in Streifenanordnung oder als Inseln angeordnet sein. Diese Inseln können kreisförmig, sechseckig oder auch anders gestaltet sein.

Eine Schottkydiode gemäß der Erfindung kann - wie oben beschreiben - eine Durchbruchsspannung haben, die größer als 100 V ist. Diese Durchbruchsspannung kann sogar größer als 600 V sein.

Eine Schottkydiode gemäß der Erfindung kann eine lötbare Vorder- und Rückseitenmetallisierung besitzen.

Eine Schottkydiode gemäß der Erfindung ist vorzugsweise in einem Einpressdiodengehäuse angeordnet und kann beispielsweise Bestandteil eines Gleichrichters eines Kraftfahrzeuggenerators sein.

**Patentansprüche**

1. Schottkydiode, aufweisend:

   - ein n$^+$-Substrat (10),
   - eine n-Epischicht (20), die eine Dicke (D_epi) aufweist,
   - mindestens zwei in die n-Epischicht (20) eingebrachte Gräben (70), die jeweils eine Breite (Wt) und eine Tiefe (Dt) aufweisen,
   - Mesabereiche (80) zwischen benachbarten Gräben (70), wobei die Mesabereiche (80) jeweils eine Breite (Wm) aufweisen,
   - eine als Kathodenelektrode dienende Metallschicht (60) an der Rückseite (R) des n$^+$-Substrat (10) der Schottkydiode und
   - eine als Anodenelektrode dienende Metallschicht (50) an der Vorderseite (V) der Schottkydiode die einen ohmschen Kontakt zu den Gräben (70) und einen Schottky-Kontakt zur n-Epischicht (20) bildet, wobei
   - für die Tiefe (Dt) der Gräben (70) und die Dicke (D_epi) der n-Epischicht (20) die folgende Beziehung gilt:

$$K \cdot Dt < D\_epi,$$

   wobei K > 4

   **dadurch gekennzeichnet,**

   - **dass** für das Verhältnis der Tiefe (Dt) der Gräben (70) zur Breite (Wm) der Mesabereiche (80) die folgende Beziehung gilt:

$$Dt/Wm \geq 2,$$

   - und **dass** gilt:

$$NA \cdot Wt \gg ND \cdot Wm,$$

   wobei NA die Dotierungskonzentration der Gräben (70), Wt die Breite der Gräben (70), ND die Dotierungskonzentration der n-Epischicht (20) und Wm die Breite des Mesabereichs (80) zwischen zwei Gräben (70) ist.

**2.** Schottkydiode nach Anspruch 1, **dadurch gekennzeichnet, dass** die Durchbruchspannung der PN-Übergänge zwischen den p-Gebieten (40a) und der n-Epischicht (20) jeweils kleiner ist als die Durchbruchspannung des Schottky-Kontaktes zwischen der Metallschicht (50) und der n-Epischicht (20).

**3.** Schottkydiode nach einem der vorhergehenden Ansprüche, **dadurch gekennzeichnet, dass** sie im Durchbruch betreibbar ist.

**4.** Schottkydiode nach einem der vorhergehenden Ansprüche, **dadurch gekennzeichnet, dass** die Gräben (70) mit p-dotiertem Silizium oder p-dotiertem Polysilizium gefüllt sind.

**5.** Schottkydiode nach einem der vorhergehenden Ansprüche, **dadurch gekennzeichnet, dass** die Gräben (70) mit Polysilizium gefüllt sind und die an der Vorderseite (V) vorgesehene Metallschicht (50) die Polysiliziumschicht kontaktiert.

**6.** Schottkydiode nach einem der Ansprüche 1 - 3, **dadurch gekennzeichnet, dass** die Gräben (70) Bor als Dotierstoff enthalten und dass die an der Vorderseite (V) vorgesehene Metallschicht (50) die Gräben (70) füllt.

**7.** Schottkydiode nach einem der vorhergehenden Ansprüche, **dadurch gekennzeichnet, dass** sie eine Durchbruchspannung aufweist, die größer als 100 V ist.

**8.** Schottkydiode nach einem der vorhergehenden Ansprüche, **dadurch gekennzeichnet, dass** alle ihre Schichten den jeweils entgegengesetzten Leitfähigkeitstyp aufweisen und die Bezeichnungen der Anoden- und Kathodenelektrode vertauscht sind.

**Claims**

**1.** Schottky diode, comprising:

- an n$^+$-type substrate (10),
- an n-type epitaxial layer (20) having a thickness (D_epi),
- at least two trenches (70) introduced into the n-type epitaxial layer (20), said trenches each having a width (Wt) and a depth (Dt),
- mesa regions (80) between adjacent trenches (70), wherein the mesa regions (80) each have a width (Wm),
- a metal layer (60) serving as a cathode electrode on the rear side (R) of the n$^+$-type substrate (10) of the Schottky diode, and
- a metal layer (50) serving as an anode electrode on the front side (V) of the Schottky diode, which forms an ohmic contact with the trenches (70) and a Schottky contact with the n-type epitaxial layer (20),

wherein

- the following relationship holds true for the depth (Dt) of the trenches (70) and the thickness (D_epi) of the n-type epitaxial layer (20):

$$K \cdot Dt < D\_epi,$$

wherein K > 4

**characterized**

- **in that** the following relationship holds true for the ratio of the depth (Dt) of the trenches (70) to the width (Wm) of the mesa regions (80):

$$Dt/Wm \geq 2,$$

- and **in that** the following holds true:

$$NA \cdot Wt \gg ND \cdot Wm,$$

wherein NA is the doping concentration of the trenches (70), Wt is the width of the trenches (70), ND is the doping concentration of the n-type epitaxial layer (20), and Wm is the width of the mesa region (80) between two trenches (70).

**2.** Schottky diode according to Claim 1, **characterized in that** the breakdown voltage of PN junctions between the p-type regions (40a) and the n-type epitaxial layer (20) is in each case less than the breakdown voltage of the Schottky contact between the metal layer (50) and the n-type epitaxial layer (20) .

**3.** Schottky diode according to either of the preceding claims, **characterized in that** it is operable at breakdown.

**4.** Schottky diode according to any of the preceding claims, **characterized in that** the trenches (70) are filled with p-doped silicon or p-doped polysilicon.

**5.** Schottky diode according to any of the preceding claims, **characterized in that** the trenches (70) are filled with polysilicon and the metal layer (50) provided on the front side (V) contacts the polysilicon layer.

**6.** Schottky diode according to any of Claims 1-3, **characterized in that** the trenches (70) contain boron as dopant, and **in that** the metal layer (50) provided on the front side (V) fills the trenches (70) .

**EP 2 786 418 B1**

**7.** Schottky diode according to any of the preceding claims, **characterized in that** it has a breakdown voltage that is greater than 100 V.

**8.** Schottky diode according to any of the preceding claims, **characterized in that** all of its layers have respectively the opposite conductivity type and the designations of the anode and cathode electrodes are interchanged.

**Revendications**

**1.** Diode Schottky, comprenant :

- un substrat n⁺ (10),
- une couche épitaxiale n (20) qui présente une épaisseur (D_epi),
- au moins deux tranchées (70) pratiquées dans la couche épitaxiale n (20), lesquelles présentent respectivement une largeur (Wt) et une profondeur (Dt),
- des zones mésa (80) entre des tranchées (70) voisines, les zones mésa (80) présentant respectivement une largeur (Wm),
- une couche en métal (60) servant d'électrode de cathode sur le côté arrière (R) du substrat n⁺ (10) de la diode Schottky et
- une couche en métal (50) servant d'électrode d'anode sur le côté avant (V) de la diode Schottky, laquelle forme un contact ohmique avec les tranchées (70) et un contact Schottky avec la couche épitaxiale n (20),
- la relation suivante s'appliquant pour la profondeur (Dt) des tranchées (70) et l'épaisseur (D_epi) de la couche épitaxiale n (20) :

$$K \cdot Dt < D\_epi,$$

avec K > 4

**caractérisée en ce**

- **que** la relation suivante s'applique pour le rapport de la profondeur (Dt) des tranchées et la largeur (Wm) des zones mésa (80) :

$$Dt/Wm \geq 2,$$

- et en ce que :

$$NA \cdot Wt \gg 2,$$

NA désignant la concentration de dopage des tranchées (70), Wt la largeur des tranchées (70), ND la concentration de dopage de la couche épitaxiale n (20) et Wm la largeur de la zone mésa (80) entre deux tranchées (70).

**2.** Diode Schottky selon la revendication 1, **caractérisée en ce que** la tension de claquage des transitions PN entre les régions p (40a) et la couche épitaxiale n (20) est respectivement plus faible que la tension de claquage du contact Schottky entre la couche en métal (50) et la couche épitaxiale n (20).

**3.** Diode Schottky selon l'une des revendications précédentes, **caractérisée en ce qu'**elle peut fonctionner en claquage.

**4.** Diode Schottky selon l'une des revendications précédentes, **caractérisée en ce que** les tranchées (70) sont remplies de silicium dopé p ou de polysilicium dopé p.

**5.** Diode Schottky selon l'une des revendications précédentes, **caractérisée en ce que** les tranchées (70) sont remplies de polysilicium et la couche en métal (50) qui se trouve sur le côté avant (V) entre en contact avec la couche en polysilicium.

**6.** Diode Schottky selon l'une des revendications 1 à 3, **caractérisée en ce que** les tranchées (70) contiennent du bore comme matériau de dopage et **en ce que** la couche en métal (50) qui se trouve sur le côté avant (V) remplit les tranchées (70).

**7.** Diode Schottky selon l'une des revendications précédentes, **caractérisée en ce qu'**elle présente une tension de claquage qui est supérieure à 100 V.

**8.** Diode Schottky selon l'une des revendications précédentes, **caractérisée en ce que** toutes ses couches présentent le type de conductivité respectivement opposé et les désignations de l'électrode d'anode et de cathode sont interverties.

EP 2 786 418 B1

**Fig. 1**

**Fig. 2**

Fig. 3

Fig. 4

Fig. 5

Fig. 6

Fig. 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19740195 C2

**In der Beschreibung aufgeführte Nicht-Patentliteratur**

- Analysis of junction-barrier-controlled Schottky (JBS) rectifier characteristics. **BALIGA et al.** SOLID STATE ELECTRONICS. ELSEVIER SCIENCE PUBLISHERS, 01. November 1985, vol. 28, 1089-1093